(19) Europäisches Patentamt
European Patent Office
Office européen des brevets

(11) **EP 3 639 044 B1**

(12) # EUROPÄISCHE PATENTSCHRIFT

(45) Veröffentlichungstag und Bekanntmachung des Hinweises auf die Patenterteilung:
**02.08.2023   Patentblatt 2023/31**

(21) Anmeldenummer: **17734983.4**

(22) Anmeldetag: **14.06.2017**

(51) Internationale Patentklassifikation (IPC):
**G01R 21/00** *(2006.01)*      **G01R 21/133** *(2006.01)*
**G01R 21/06** *(2006.01)*

(52) Gemeinsame Patentklassifikation (CPC):
**G01R 21/1331**; G01R 21/06; H02H 7/001;
Y02E 40/60

(86) Internationale Anmeldenummer:
**PCT/EP2017/000698**

(87) Internationale Veröffentlichungsnummer:
**WO 2018/228655 (20.12.2018 Gazette 2018/51)**

(54) **SCHALTFREQUENZBASIERTE WIRKLEISTUNGSBESTIMMUNG**

DETERMINATION OF ACTIVE POWER ON THE BASIS OF THE SWITCHING FREQUENCY

DÉFINITION DE LA PUISSANCE ACTIVE SUR LA BASE D'UNE FRÉQUENCE DE COMMUTATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**22.04.2020   Patentblatt 2020/17**

(73) Patentinhaber: HBM Netherlands B.V.
**5145 NP Waalwijk (NL)**

(72) Erfinder:
• STOCK, Alexander
  63739 Aschaffenburg (DE)
• TEIGELKÖTTER, Johannes
  63741 Aschaffenburg (DE)
• KOWALSKI, Thomas
  63776 Mömbris (DE)
• STAUDT, Stefan
  63743 Aschaffenburg (DE)
• ACKERMANS, Peter
  5141 EM Waalwijk (NL)
• LANG, Klaus
  63811 Stockstadt (DE)

(74) Vertreter: **Staudte, Ralph**
**Patentanwalt**
**Boschetrieder Str. 20**
**81379 München (DE)**

(56) Entgegenhaltungen:
EP-A1- 3 086 453          WO-A1-2010/018424
CN-U- 203 812 128         DE-A1- 3 429 116
DE-A1-102012 210 732      DE-T2- 69 229 847
JP-A- S6 489 412          US-A- 5 301 121
US-A- 6 034 517           US-A1- 2004 227 476

• SEPE R B ED - INSTITUTE OF ELECTRICAL AND ELECTRONICS ENGINEERS: "QUASI-BEHAVIOR MODEL OF A VOLTAGE FED INVERTER AND CLOSED-LOOP CURRENT CONTROLLER MODELING", RECORD OF THE ANNUAL POWER ELECTRONICS SPECIALISTS CONFERENCE (PESC). ATLANTA, JUNE 12 - 15, 1995; [RECORD OF THE ANNUAL POWER ELECTRONICS SPECIALISTS CONFERENCE (PESC)], NEW YORK, IEEE, US, Bd. 1, 12. Juni 1995 (1995-06-12), Seiten 464-470, XP000548444, ISBN: 978-0-7803-2731-3
• ZHU JIAHUI ET AL: "Design, dynamic simulation and construction of a hybrid HTS SMES (high-temperature superconducting magnetic energy storage systems) for Chinese power grid", ENERGY, ELSEVIER, AMSTERDAM, NL, Bd. 51, 11. November 2012 (2012-11-11), Seiten 184-192, XP029000136, ISSN: 0360-5442, DOI: 10.1016/J.ENERGY.2012.09.044

- NANATO N ET AL: "Development of quench detection/protection system based on active power method for superconducting magnet by using capacitor circuit", PHYSICA C, NORTH-HOLLAND PUBLISHING, AMSTERDAM, NL, Bd. 484, 3. April 2012 (2012-04-03), Seiten 305-309, XP028525982, ISSN: 0921-4534, DOI: 10.1016/J.PHYSC.2012.03.061
- JOO J H ET AL: "Quench protection technique for HTS coils with electronic workbench", PHYSICA C, Bd. 470, Nr. 20, 1. November 2010 (2010-11-01), Seiten 1874-1879, XP028168030, ISSN: 0921-4534, DOI: 10.1016/J.PHYSC.2010.05.226 [gefunden am 2010-05-16]

**Beschreibung**

Die vorliegende Erfindung bezieht sich auf ein Verfahren zur schaltfrequenzbasierten Bestimmung der Wirkleistung einer elektrischen Einrichtung, insbesondere einer supraleitenden elektrischen Einrichtung, und eine Vorrichtung zum Ausführen eines derartigen Verfahrens.

Der Wirkungsgrad eines elektrischen Systems ist eine der wichtigsten Kenngrößen eines solchen Systems. Allgemein ist der Wirkungsgrad eines Systems das Verhältnis von abgegebener zu zugeführter Leistung. Bei elektrischen Systemen wird als Leistung die sogenannte Wirkleistung ermittelt, welche den mittleren Energiefluss pro Zeiteinheit eines Systems charakterisiert. Gemäß der grundlegenden Definition

$$ P = \frac{1}{T} \cdot \int_{t}^{t+T} u(\tau) \cdot i(\tau) \, d\tau $$

in DIN 40110-1:1994-03: Wechselstromgrößen; Zweileiter-Stromkreise, 03.1994 wird zyklisch der zeitliche Mittelwert der Augenblicksleistung (Produkt aus Spannung und Strom) gebildet, wobei als Periode für die Bildung des Mittelwerts die Grundschwingungsperiode T der elektrischen Wechselgrößen verwendet und ein stationär eingeschwungener Zustand des Systems vorausgesetzt wird.

In verschiedenen elektrischen Systemen können Supraleiter eingesetzt werden, um Energieverluste durch ohmsche Widerstände zu vermeiden und dadurch den Wirkungsgrad zu steigern. Dabei geben neue Entwicklungen wie beispielsweise die im Jahr 2015 von Forschern des Mainzer Max-Planck-Instituts für Chemie und der Johannes Gutenberg-Universität Mainz veröffentlichte Entdeckung, dass Schwefelwasserstoff ($H_2S$) unter Hochdruck schon bei -70 °C supraleitend wird, Anlass zu der Hoffnung, dass in absehbarer Zeit sogar Supraleitung bei Raumtemperatur möglich sein wird. Dies würde die Nutzung des Supraleitungseffekts in nahezu jedem elektrischen System erlauben. Schon heute ist aber beispielsweise der Einsatz von Supraleitern in Magnetresonanztomographiesystemen, in elektrischen Maschinen wie Motoren oder Generatoren und für andere Anwendungen, bei denen man Supraleiter bereits mit vertretbarem technischem Aufwand verwenden kann, möglich.

Supraleiter können aus verschiedenen Gründen ungewollt von ihrem supraleitenden in ihren normalleitenden Zustand übergehen. Dies kann beispielsweise bei einem Ausfall der Kühlung des Supraleiters oder einem anderen Störungsfall geschehen. Der dann auftretende abrupte Übergang von dem supraleitenden Zustand in den normalleitenden Zustand wird auch als Quench bezeichnet. Die Normalleitung setzt meistens in einem Abschnitt des Supraleiters ein und breitet sich dann weiter aus. Durch den in dem normalleitenden Zustand des Supraleiters vorhandenen ohmschen Widerstand entstehen schnell hohe Spannungen und Temperaturen. In der Folge kann es zu Spannungsüberschlägen und einer Überhitzung des Supraleiters kommen, was letzten Endes zu einer Zerstörung des Supraleiters führen kann. Beim Einsatz eines Supraleiters gilt es daher, einen Quench und/oder seine negativen und unter Umständen fatalen Auswirkungen zu verhindern.

Es sind Maßnahmen bekannt, die dann, wenn ein Quench auftritt, seine negativen Folgen verhindern oder wenigstens abmildern. So kann beispielsweise der Supraleiter mit einer Normalleiterschicht, deren ohmscher Widerstand unterhalb des ohmschen Widerstands des Supraleiters in seinem normalleitenden Zustand liegt, umgeben sein oder es kann ein separater ohmscher Widerstand parallel zu dem Supraleiter geschaltet sein. Dadurch kann erreicht werden, dass es in dem Fall des bereichsweisen Übergangs des Supraleiters von dem supraleitenden in den normalleitenden Zustand zu einem Kurzschluss über die ihn umgebende Normalleiterschicht oder den separaten ohmschen Widerstand kommt und sich dadurch der Supraleiter nur langsam erwärmt. Allerdings erhöht sich die elektrische Zeitkonstante einer supraleitenden Spule durch einen parallel zu ihr geschalteten ohmschen Widerstand deutlich.

Es sind auch verschiedene Maßnahmen bekannt, um einen Quench zu detektieren. So kann z. B. mittels spezieller Sensoren die an dem Supraleiter anliegende Spannung, der durch den Supraleiter fließende Strom oder das durch den Supraleiter erzeugte Magnetfeld überwacht werden, um eine plötzliche Veränderung einer dieser Größen, die durch einen Quench bedingt sein kann, zu erkennen. Wenn auf diese Weise ein Quench detektiert wird, kann die Energieversorgung des Supraleiters unterbrochen werden, um negative Auswirkungen zu verhindern. Derartige Maßnahmen sind beispielsweise in dem Dokument US 3,336,526 A beschrieben. Bei diesem bekannten Ansatz sind jedoch immer zusätzliche Sensoren wie beispielsweise Voltmeter zur Überwachung der Spannung oder Hall-Sensoren zur Überwachung des Magnetfelds erforderlich. WO 2010/018424 A1 und US 5 301 121 A offenbaren relevante Ansätze zur Bestimmung einer Wirkleistung einer mehrphasigen elektrischen Einrichtung.

Es ist die Aufgabe der Erfindung, ein Verfahren und eine Vorrichtung zu dessen Ausführung bereitzustellen, die bei einer supraleitenden elektrischen Einrichtung eine schnelle Quench-Detektion ohne den Einsatz von zusätzlichen Sensoren ermöglichen und darüber hinaus den Wirkungsgrad der elektrischen Einrichtung sehr dynamisch ermitteln können.

Diese Aufgabe wird mit dem Verfahren nach dem unabhängigen Anspruch 1 und der Vorrichtung nach dem unabhängigen Anspruch 9 gelöst. Vorteilhafte Weiterbildungen sind in den abhängigen Ansprüchen angegeben.

Nach Anspruch 1 werden bei einem Verfahren zur schaltfrequenzbasierten Bestimmung einer Wirkleistung einer mehrphasigen elektrischen Einrichtung, die über einen Stromrichter mit einer Spannung, die eine frequenz- und amplitudenvariable Grundschwingung mit einer Grundschwingungsperiode T aufweist, versorgt wird oder dem Stromrichter eine derartige Spannung zuführt, Spannungen $u_{1i} = u_1(i \cdot T_{ABTAST})$ bis $u_{xi} = u_x(i \cdot T_{ABTAST})$ und Ströme $i_{1i} = i_1(i \cdot T_{ABTAST})$ bis $i_{xi} = i_x(i \cdot T_{ABTAST})$ der elektrischen Phasen für Zeitpunkte $i \cdot T_{ABTAST}$ gemessen, wobei x eine Anzahl der elektrischen Phasen ist und $T_{ABTAST}$ eine Abtastzeit einer für die Messung verwendeten Messeinrichtung ist. Die gemessenen Spannungen $u_{1i}$ bis $u_{xi}$ und Ströme $i_{1i}$ bis $i_{xi}$ werden gespeichert. Augenblicksleistungen $p_i = p(i \cdot T_{ABTAST})$ werden als jeweilige Summe der Produkte $u_{1i} \cdot i_{1i}$ bis $u_{xi} \cdot i_{xi}$ der gemessenen Spannungen und Ströme für den entsprechenden Zeitpunkt berechnet. Eine Schaltperiode $T_s$ des Stromrichters wird ermittelt. Daraufhin wird eine Wirkleistung $P_S$ der elektrischen Einrichtung als Mittelwert der Augenblicksleistungen $p_i$ zu Zeitpunkten innerhalb der Schaltperiode $T_s$ bestimmt.

Mit dem Verfahren kann bereits nach der Schaltperiode $T_s$ des Stromrichters und somit sehr schnell eine Wirkleistung $P_S$ der elektrischen Einrichtung bestimmt werden. Da sich diese Wirkleistung bei einem Quench eines Supraleiters der elektrischen Einrichtung abrupt verändert, kann durch die Überwachung der Wirkleistung $P_S$ ein Quench schnell genug detektiert werden, was mit der deutlich langsameren Wirkleistungsbestimmung gemäß der vorstehend erläuterten grundlegenden Definition nicht möglich ist. Dabei sind keine zusätzlichen Sensoren erforderlich, weil die ohnehin schon zum Zweck des Ermittelns des Wirkungsgrads der elektrischen Einrichtung bestimmte Wirkleistung $P_S$ gleichzeitig auch für die Quench-Detektion genutzt wird.

Durch die Bestimmung der Wirkleistung $P_s$ der elektrischen Einrichtung nach der Schaltperiode $T_s$ des Stromrichters und somit nach einem Bruchteil der Grundschwingungsperiode T ist es zudem möglich, den Wirkungsgrad der elektrischen Einrichtung sehr dynamisch zu bestimmen. Durch die schnelle Bestimmung der Wirkleistung $P_s$ auf der Grundlage der Schaltperiode $T_s$ des Stromrichters können auch abrupte Änderungen der Wirkleistung bei Arbeitspunktänderungen und Ausgleichsvorgängen erfasst werden. Ebenso können Transienten in der Augenblicksleistung $p(t)$ erfasst werden, die bei der Wirkleistungsbestimmung gemäß der vorstehend erläuterten grundlegenden Definition, die nur für den stationär eingeschwungenen Zustand des elektrischen Systems gilt, nicht zu erkennen sind.

Es lässt sich zudem nachweisen, dass in dem stationär eingeschwungenen Zustand und unter der idealen Annahme einer unendlich hohen Schaltfrequenz eines mit Sinus-Pulsweitenmodulation betriebenen Stromrichters die basierend auf der Schaltperiode $T_s$ des Stromrichters bestimmte Wirkleistung $P_s$, d. h. die schaltfrequenzbasierte Wirkleistung, mit der basierend auf der Grundschwingungsperiode T bestimmten Wirkleistung P gemäß der vorstehend erläuterten grundlegenden Definition, d. h. der grundschwingungsfrequenzbasierten Wirkleistung, übereinstimmt. Somit ist mit dem Verfahren eine sowohl dynamische als auch genaue Bestimmung der Wirkleistung der elektrischen Einrichtung möglich.

Die Übereinstimmung mit der basierend auf der Grundschwingungsperiode T bestimmten Wirkleistung P in dem stationär eingeschwungenen Zustand unter der beschriebenen idealen Annahme gilt auch für eine Bestimmung der Wirkleistung $P_s$ über ein ganzzahliges Vielfaches der Schaltperiode $T_s$ des Stromrichters. Abweichungen von der Schaltperiode $T_s$ oder einem ganzzahligen Vielfachen derselben bei der Bestimmung der Wirkleistung $P_s$ führen jedoch zu einer zunehmend geringeren Übereinstimmung. Wenn die möglichst dynamische und zugleich auch möglichst genaue Bestimmung der Wirkleistung gewünscht ist, wird daher in der Regel die Wirkleistung $P_s$ für genau eine Schaltperiode $T_s$ des Stromrichters bestimmt, d. h. als Mittelwert aller Augenblicksleistungen für Zeitpunkte in der Schaltperiode $T_S$.

Nach Anspruch 2 ist die elektrische Einrichtung eine elektrische Einrichtung mit einem Supraleiter und die bestimmte Wirkleistung $P_s$ wird analysiert, um einen Übergang des Supraleiters von dem supraleitenden Zustand zu dem normalleitenden Zustand in zumindest einem Teil des Supraleiters zu detektieren. Wenn ein Übergang in den normalleitenden Zustand detektiert wird, dann wird ein Energiefluss zwischen der elektrischen Einrichtung und dem Stromrichter unterbrochen. Wie vorstehend beschrieben können sehr schnell eine Wirkleistung $P_s$ der elektrischen Einrichtung bestimmt und somit auch ein Quench des Supraleiters erkannt werden. Durch die daraufhin erfolgende Unterbrechung des Energieflusses zwischen der elektrischen Einrichtung und dem Stromrichter kann eine Zerstörung des Supraleiters verhindert werden.

Nach Anspruch 3 wird in dem Schritt des Ermittelns die Schaltperiode $T_s$ auf der Grundlage des Verlaufs einer Ausgangsspannung des Stromrichters für eine der elektrischen Phasen ermittelt. Somit wird eine ohnehin im Zusammenhang mit der Wirkleistungsbestimmung gemessene Größe gleichzeitig auch für die Ermittlung der Schaltperiode $T_s$ herangezogen.

Nach Anspruch 4 gilt $T_s \leq T/5$, d. h. die Dauer der Schaltperiode $T_S$ beträgt höchstens 20 % der Dauer der Grundschwingungsperiode T bzw. die Schaltfrequenz des Stromrichters ist mindestens fünfmal so groß wie die Frequenz der Grundschwingung. Schon bei einer in der Praxis kaum vorkommenden Schaltfrequenz des Stromrichters in dieser Größenordnung ist eine deutlich schnellere Wirkleistungsbestimmung, die für die Quench-Detektion und die Erfassung abrupter Wirkleistungsänderungen ausreicht, möglich.

Nach Anspruch 5 gilt $T_s \leq T/100$, d. h. die Dauer der Schaltperiode $T_S$ beträgt höchstens 1 % der Dauer der Grundschwingungsperiode T bzw. die Schaltfrequenz des Stromrichters ist mindestens hundertmal so groß wie die Frequenz der Grundschwingung. Bei einer Schaltfrequenz des Stromrichters in dieser Größenordnung sind eine noch schnellere Quench-Detektion und eine Erfassung noch dynamischerer Wirkleistungsänderungen möglich.

Nach Anspruch 6 wird die bestimmte Wirkleistung $P_s$ analysiert, um eine Transiente in der Augenblicksleistung p(t) zu detektieren. Wird eine solche Transiente erkannt, dann wird ein bei ihr erreichter Leistungsspitzenwert ermittelt. Daraufhin wird bestimmt, ob der erreichte Leistungsspitzenwert einen Grenzwert für eine kurzzeitige Maximalleistung überschreitet. Auf diese Weise können auch Transienten, die zu Maximalleistungsüberschreitungen führen und bei der Wirkleistungsbestimmung auf der Grundlage der Grundschwingungsperiode T nicht erkennbar sind, erfasst werden. Dies ermöglicht es, derartige Belastungsüberschreitungen, die ebenso wie andere Belastungsüberschreitungen zu Schäden an verschiedenen Systemkomponenten führen können, mit zu berücksichtigen.

Nach Anspruch 7 wird die bestimmte Wirkleistung $P_s$ analysiert, um einen Übergang zwischen unterschiedlichen Arbeitspunkten der elektrischen Einrichtung zu detektieren. Der detektierte Übergang wird dann bei der Regelung der Wirkleistung der elektrischen Einrichtung berücksichtigt. Dadurch können die Dynamik und die Regelgüte verbessert werden.

Nach Anspruch 8 werden die Verfahrensschritte zyklisch wiederholt. Somit können die Wirkleistung $P_s$ kontinuierlich neu bestimmt und die auf ihr basierenden Analysen immer aktuell gehalten werden.

Die Vorrichtung nach Anspruch 9 zum Ausführen des Verfahrens weist die gleichen Vorteile auf wie das Verfahren selbst, wobei diese Vorteile bereits vorstehend im Zusammenhang mit dem Verfahren beschrieben sind. Dies gilt auch für das System nach Anspruch 10 unter Einbeziehung der Vorrichtung.

Die Erfindung wird nachfolgend anhand eines Ausführungsbeispiels in Verbindung mit schematischen Zeichnungen näher erläutert. Es zeigen:

Fig. 1 ein vereinfachtes Blockschaltbild eines elektrischen Systems;

Fig. 2 ein Flussdiagramm mit Schritten eines Verfahrens zur schaltfrequenzbasierten Bestimmung der Wirkleistung einer elektrischen Einrichtung;

Fig. 3 die Augenblicksleistung p(t), die grundschwingungsfrequenzbasierte Wirkleistung P und die schaltfrequenzbasierte Wirkleistung $P_s$;

Fig. 3a die hervorgehobene schaltfrequenzbasierte Wirkleistung $P_s$;

Fig. 3b die hervorgehobene grundschwingungsfrequenzbasierte Wirkleistung P; und

Fig. 4 Leistungsbeziehungen bei einer Variation eines Mittelungsintervalls.

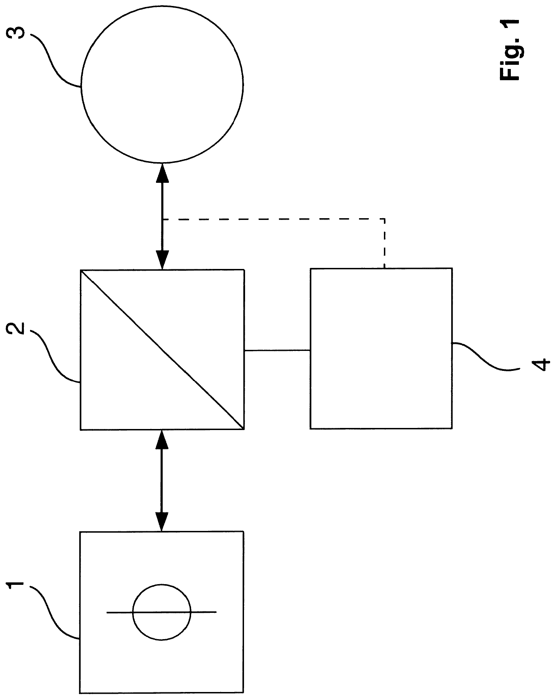

Fig. 1 zeigt ein vereinfachtes Blockschaltbild eines elektrischen Systems gemäß einem Ausführungsbeispiel, das eine Energiequelle oder -senke 1, einen Stromrichter 2 mit einer Schaltfrequenz $f_S$ und einer Schaltperiode $T_s$, eine elektrische Einrichtung 3 und eine Verarbeitungseinrichtung 4 umfasst. Es handelt sich um ein mehrphasiges System mit elektrischen Phasen 1 bis x, beispielsweise um das bekannte Dreiphasensystem. Die elektrische Einrichtung 3 ist somit auch eine mehrphasige elektrische Einrichtung.

Bei der elektrischen Einrichtung 3 kann es sich um eine Spule, eine elektrische Maschine wie beispielsweise einen elektrischen Antrieb (Elektromotor und unter Umständen auch Getriebe) oder einen Generator, oder eine andere elektrische Komponente handeln, wobei die elektrische Einrichtung 3 vorzugsweise einen Supraleiter aufweist. Je nachdem fließt elektrische Energie von der Energiequelle oder -senke 1 über den Stromrichter 2 zu der elektrischen Einrichtung 3 oder umgekehrt, was durch Doppelpfeile zwischen der Energiequelle oder -senke 1 und dem Stromrichter 2 sowie zwischen dem Stromrichter 2 und der elektrischen Einrichtung 3 dargestellt ist. In dem ersteren Fall kommt eine Energiequelle 1 zum Einsatz, und der Stromrichter 2 erzeugt aus der von ihr gelieferten elektrischen Energie eine Spannung, die eine frequenz- und amplitudenvariable Grundschwingung mit einer Grundschwingungsperiode T aufweist, und führt diese der elektrischen Einrichtung 3 zu. In dem letzteren Fall kommt eine Energiesenke 1 zum Einsatz, und ihr wird von dem Stromrichter 2 die elektrische Energie zugeführt, welche dieser aus einer von der elektrischen Einrichtung 3 gelieferten derartigen Spannung erzeugt.

Die Schaltfrequenz $f_S$ des Stromrichters 2 ist mindestens fünfmal so groß wie die Frequenz der Grundschwingung und in der Regel mindestens hundertmal so groß wie die Frequenz der Grundschwingung oder sogar noch deutlich größer, so dass seine Schaltperiode $T_s$ immer erheblich kürzer ist als die Grundschwingungsperiode T der Grundschwingung. Der Stromrichter 2 kann beispielsweise ein Frequenzumrichter sein.

In der Verarbeitungseinrichtung 4 oder auch in dem Stromrichter 2 kann eine nicht in Fig. 1 dargestellte Messeinrichtung integriert sein. Diese kann ebenso als separates Element vorgesehen sein. Eine durchgezogene Linie zwischen der Verarbeitungseinrichtung 4 und dem Stromrichter 2 sowie eine gestrichelte Linie zwischen der Verarbeitungseinrichtung 4 und dem den Stromrichter 2 und die elektrische Einrichtung 3 verbindenden Doppelpfeil symbolisieren einerseits, dass die Verarbeitungseinrichtung 4 bzw. eine darin integrierte Messeinrichtung direkt von dem Stromrichter 2 stammende Messwerte und/oder an der Verbindung von Stromrichter 2 und elektrischer Einrichtung 3 auftretende Messwerte wie Spannungs- und Stromwerte erfassen kann. Diese beiden Linien symbolisieren andererseits auch, dass Steuersignale von der Verarbeitungseinrichtung 4 dem Stromrichter 2 und/oder nicht in Fig. 1 dargestellten Elementen an der Verbindung zwischen dem Stromrichter 2 und der elektrischen Einrichtung 3 zugeführt werden können, um z. B. den Energiefluss zu oder von der elektrischen Einrichtung 3 mittels entsprechender Schaltelemente wie beispielsweise Metall-Oxid-Halbleiter-Feldeffekttransistoren (MOSFETs) zu unterbrechen.

Bei der Verarbeitungseinrichtung 4 kann es sich beispielsweise um eine Vorrichtung wie ein Modul eines Messdatenerfassungssystems, einen Mikrocontroller oder eine ähnliche Vorrichtung handeln. Die Verarbeitungseinrichtung 4 kann z. B. ein Echtzeitmodul eines Messdatenerfassungssystems sein. Sie muss nicht als separates Element oder Teil eines separaten Messdatenerfassungssystems vorhanden sein wie beispielhaft in Fig. 1 dargestellt, sondern kann auch in dem Stromrichter 2 oder einer anderen Komponente des elektrischen Systems gemäß dem Ausführungsbeispiel integriert sein. Sie verarbeitet Werte wie beispielsweise die von der Messeinrichtung gelieferten Messwerte, wobei dies in Echtzeit geschehen kann. Sie kann Steuersignale erzeugen, was ebenfalls in Echtzeit möglich ist. Die Verarbeitungseinrichtung 4 kann auch dazu in der Lage sein, Messwerte und verarbeitete Werte zwischenzuspeichern oder dauerhaft zu speichern, wobei diese Speicherung ebenso an einem anderen Ort erfolgen kann.

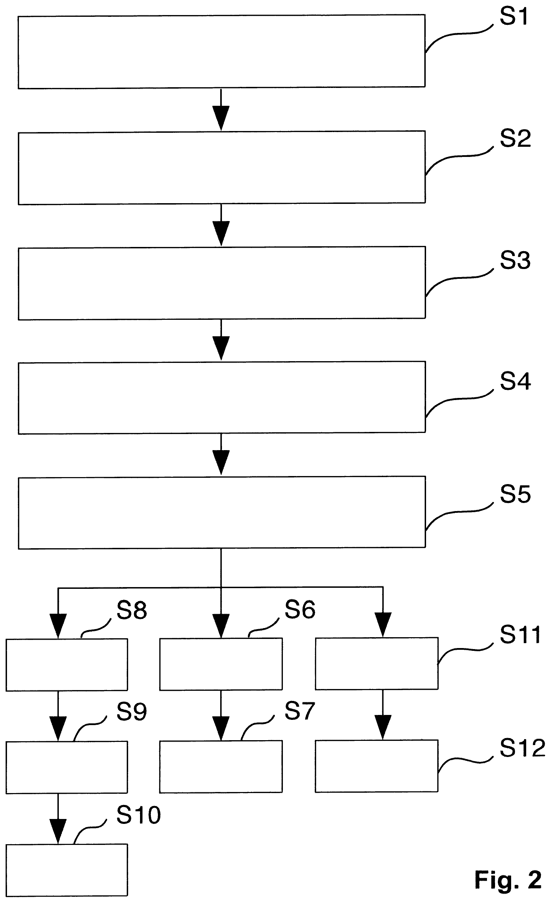

Fig. 2 zeigt ein Flussdiagramm mit Schritten eines Verfahrens zur schaltfrequenzbasierten Bestimmung einer Wirkleistung $P_S$ der elektrischen Einrichtung 3. In einem Schritt S1 werden Spannungen $u_{1i} = u_1(i \cdot T_{ABTAST})$ bis $u_{xi} = u_x(i \cdot T_{ABTAST})$ und Ströme $i_{1i} = i_1(i \cdot T_{ABTAST})$ bis $i_{xi} = i_x(i \cdot T_{ABTAST})$ der elektrischen Phasen 1 bis x für Zeitpunkte $i \cdot T_{ABTAST}$ gemessen, wobei $T_{ABTAST}$ eine Abtastzeit der für die Messung verwendeten Messeinrichtung ist. In einem Schritt S2 werden die gemessenen Spannungen $u_{1i}$ bis $u_{xi}$ und Ströme $i_{1i}$ bis $i_{xi}$ gespeichert, wobei es sich um eine dauerhafte oder eine temporäre Speicherung handeln kann. Die Speicherung oder Zwischenspeicherung der Werte kann in einem Speicher in der Verarbeitungseinrichtung 4 oder an einem anderen Ort erfolgen. In einem Schritt S3 werden Augenblicksleistungen $p_i = p(i \cdot T_{ABTAST})$ für jeden Zeitpunkt $i \cdot T_{ABTAST}$ als jeweilige Summe der Produkte $u_{1i} \cdot i_{1i}$ bis $u_{xi} \cdot i_{xi}$ der für den entsprechenden Zeitpunkt gemessenen Spannungen und Ströme berechnet, was in der Verarbeitungseinrichtung 4 geschehen kann. In einem Schritt S4 wird die Schaltperiode $T_s$ des Stromrichters 2 ermittelt, was beispielsweise auf der Grundlage des Verlaufs einer Ausgangsspannung des Stromrichters 2 für eine der elektrischen Phasen 1 bis x geschehen kann. Es kann z. B. auf den Nulldurchgang einer der Spannungen $u_1(t)$ bis $u_x(t)$ oder eine andere Spannung zwischen einer der elektrischen Phasen und einem geeigneten Referenzpunkt wie beispielsweise dem Sternpunkt der elektrischen Einrichtung 3 oder einem Bezugspunkt an der Energiequelle oder -senke 1 abgestellt werden. In einem Schritt S5 wird dann die Wirkleistung $P_S$ der elektrischen Einrichtung 3 als zeitlicher Mittelwert der Augenblicksleistungen $p_i$ zu Zeitpunkten innerhalb der Schaltperiode $T_s$, d.h. für $i \in [1, T_S/T_{ABTAST}]$, bestimmt. Mit anderen Worten wird die schaltfrequenzbasierte Wirkleistung $P_s$ ermittelt. Dies wird für jede weitere Schaltperiode $T_s$ erneut durchgeführt. Bei entsprechender Auslegung der Verarbeitungseinrichtung 4 können alle Schritte S1 bis S5 durch die Verarbeitungseinrichtung 4 ausgeführt werden.

In einem Schritt S6 wird die bestimmte Wirkleistung $P_s$ analysiert, um einen Übergang des Supraleiters der elektrischen Einrichtung 3 von dem supraleitenden Zustand zu dem normalleitenden Zustand in zumindest einem Teil des Supraleiters zu detektieren. In einem Schritt S7 wird dann, wenn ein Übergang in den normalleitenden Zustand detektiert wird, ein Energiefluss zwischen dem Stromrichter 2 und der elektrischen Einrichtung 3 unterbrochen. Diese Schritte werden dann ausgeführt, wenn die elektrische Einrichtung 3 einen Supraleiter aufweist. Die Analyse und die Steuerung der Unterbrechung des Energieflusses können durch die Verarbeitungseinrichtung 4 erfolgen, wobei die eigentliche Unterbrechung des Energieflusses über die vorstehend erwähnten Schaltelemente wie beispielsweise MOSFETs realisiert werden kann.

In einem Schritt S8 wird die bestimmte Wirkleistung $P_S$ analysiert, um eine Transiente in der Augenblicksleistung $p(t)$ zu detektieren. In dem Schritt S9 wird ein bei der detektierten Transiente erreichter Leistungsspitzenwert ermittelt. Daraufhin wird in einem Schritt S10 bestimmt, ob der erreichte Leistungsspitzenwert einen Grenzwert für eine kurzzeitige Maximalleistung überschreitet. Diese Schritte können durch die Verarbeitungseinrichtung 4 ausgeführt werden. Sie sind nur dann erforderlich, wenn eine Überwachung der Überschreitung des Grenzwerts gewünscht wird, um z. B. mögliche Schäden an den elektrischen Komponenten durch eine derartige Überschreitung verhindern oder zumindest frühzeitig erkennen zu können.

In einem Schritt S11 wird die bestimmte Wirkleistung $P_s$ analysiert, um einen Übergang zwischen unterschiedlichen Arbeitspunkten der elektrischen Einrichtung 3 zu detektieren. In einem Schritt S12 wird die Wirkleistung der elektrischen Einrichtung 3 unter Berücksichtigung des detektierten Übergangs geregelt. Die Analyse und die Regelung können durch die Verarbeitungseinrichtung 4 erfolgen. Sie müssen nicht immer durchgeführt werden, sondern nur dann, wenn die Wirkleistung geregelt werden soll.

Die vorstehend beschriebenen Schritte können komplett oder teilweise zyklisch wiederholt werden. Ebenso können zwischen oder nach diesen Schritten noch weitere Schritte ausgeführt werden, die nicht im Einzelnen beschrieben sind.

Bei der vorstehend erläuterten schaltfrequenzbasierten Wirkleistung handelt es sich um eine neue Definition der Wirkleistungsgröße. Ihre Berechnung erfolgt wie vorstehend beschrieben, indem der zeitliche Mittelwert der Augenblicksleistungen für die Schaltperiode $T_S$ bestimmt wird, was sich auch durch die Gleichung

$$P_S = \frac{1}{T_S} \cdot \int_{t}^{t+T_S} u(\tau) \cdot i(\tau)\, d\tau$$

ausdrücken lässt.

In den vorstehend beschriebenen und vielen weiteren Anwendungsfällen wird die Ausgangsspannung des Stromrichters 2 mittels eines Pulsweitenmodulationsverfahrens erzeugt. Als Modulationsfunktionen werden meistens sinusförmige Signale verwendet, auf welche in Abhängigkeit vom Arbeitspunkt der elektrischen Einrichtung ein für diesen Bereich geeignetes Nullsystem addiert wird. Mit anderen Worten wird zumeist eine Sinus-Pulsweitenmodulation eingesetzt.

Für die in Fig. 1 dargestellte elektrische Einrichtung 3, bei welcher der Sternpunkt nicht kontaktiert ist, trägt das Spannungsnullsystem nicht zur Augenblicksleistung bzw. Wirkleistung bei. Es lässt sich für diesen Fall mathematisch zeigen, dass im eingeschwungenen Zustand und unter der idealen Annahme einer unendlich hohen Schaltfrequenz $f_S$ und des mit einer Sinus-Pulsweitenmodulation (mit beliebigem Nullsystem) betriebenen Stromrichters 2 in Form eines Frequenzumrichters die schaltfrequenzbasierte Wirkleistungsberechnung analytisch exakt mit der grundschwingungsfrequenzbasierten Wirkleistungsberechnung übereinstimmt und somit

$$\lim_{f_S \to \infty} P_S = P$$

gilt.

In diesem theoretischen Idealfall wird die Analogie der beiden unterschiedlichen Wirkleistungsdefinitionen deutlich. Bei der schaltfrequenzbasierten Wirkleistungsberechnung wird der Mittelwert über eine gegenüber der Grundschwingungsperiode T viel kürzere Periode gebildet. Somit ist die schaltfrequenzbasierte Wirkleistung eine Wirkleistungsgröße, welche zum einen die Dynamik eines elektrischen Systems erfasst und zum anderen unter den genannten Rahmenbedingungen im stationär eingeschwungenen Zustand die gleichen Ergebnisse wie die typische Wirkleistungsberechnung gemäß der einleitend erläuterten grundlegenden Definition liefert. Letztere ist wie erwähnt ausschließlich für diesen stationär eingeschwungenen Zustand definiert.

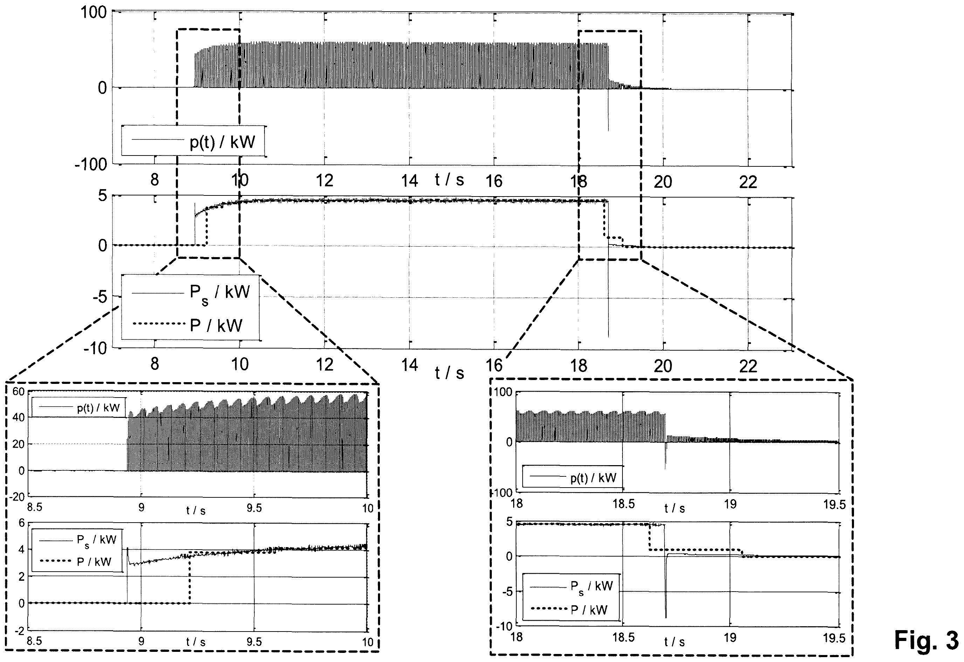

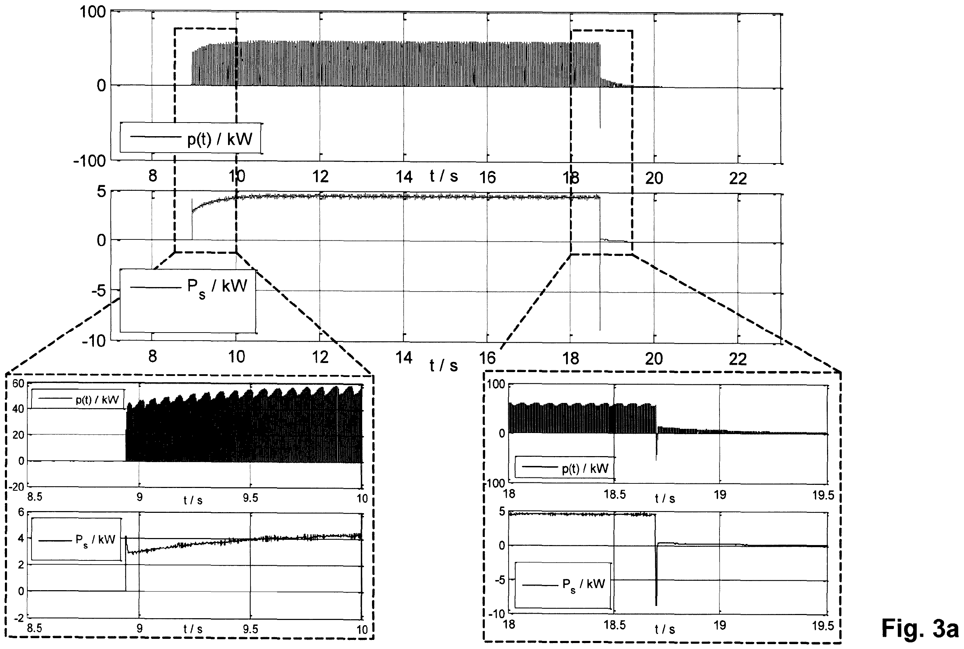

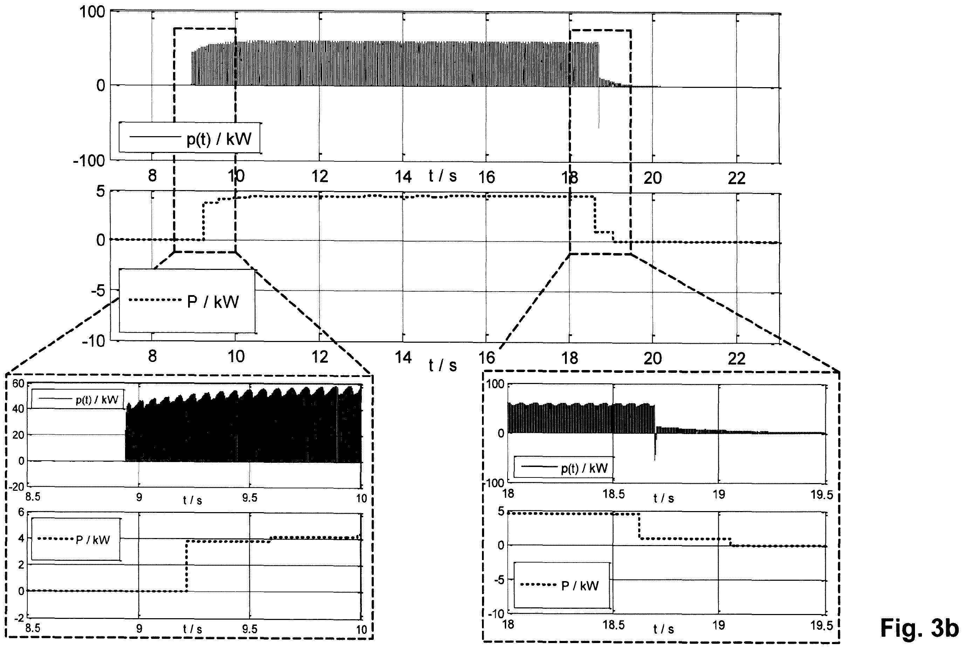

Fig. 3 zeigt die Augenblicksleistung p(t), die grundschwingungsfrequenzbasierte Wirkleistung P und die schaltfrequenzbasierte Wirkleistung $P_s$. Zur besseren Verdeutlichung sind zudem in Fig. 3a die schaltfrequenzbasierte Wirkleistung $P_s$ und in Fig. 3b die grundschwingungsfrequenzbasierte Wirkleistung P hervorgehoben.

Aufgrund des viel kürzeren Mittelungsintervalls liefert die schaltfrequenzbasierte Wirkleistungsberechnung wesentlich dynamischere Wirkleistungswerte. Dies ist in Fig. 3, Fig. 3a und Fig. 3b jeweils in der links unten gezeigten vergrößerten Darstellung zu erkennen. Im schlechtesten Fall wird eine Änderung der grundschwingungsfrequenzbasierten Wirkleistung P mit einer der Grundschwingungsperiode T entsprechenden Verspätung angezeigt. Hingegen wird eine Änderung der schaltfrequenzbasierten Wirkleistung $P_s$ mit einer Verzögerung von maximal der Schaltperiode $T_s$ angezeigt. Somit lässt die schaltfrequenzbasierte Wirkleistung $P_s$ den Lastanstieg bzw. neuen Arbeitspunkt annähernd zeitgleich mit der Augenblicksleistung p(t) erkennen.

Im mittleren Bereich, d. h. bei einem stationären Arbeitspunkt, sind die grundschwingungsfrequenzbasierte Wirkleistung P und die schaltfrequenzbasierte Wirkleistung $P_S$ nahezu identisch.

Beim Übergang des Arbeitspunkts zurück in den Leerlauf erfasst die schaltfrequenzbasierte Wirkleistungsberechnung auch die Transienten der Augenblicksleistung p(t), so dass diese in der schaltfrequenzbasierten Wirkleistung $P_s$ erkennbar sind. Hingegen sind die Transienten der Augenblicksleistung p(t) in der grundschwingungsfrequenzbasierten Wirkleistung P nicht erkennbar, da sie aufgrund der Langzeit-Mittelung nicht mehr enthalten sind. Dies ist in Fig. 3, Fig. 3a und Fig. 3b jeweils in der rechts unten gezeigten vergrößerten Darstellung zu erkennen.

Weiterhin ist in Fig. 3, Fig. 3a und Fig. 3b jeweils in der rechts unten gezeigten vergrößerten Darstellung auch zu erkennen, dass die grundschwingungsfrequenzbasierte Wirkleistung P einen unrealistischen Zwischenwert annehmen kann Dies liegt daran, dass bei einem Lastwechsel zwar mittels einer Detektion des Nulldurchgangs ein Grundschwingungszyklus gefunden wird, das Signal innerhalb dieses Zyklus jedoch nicht dem periodisch fortgesetzten Signal des stationären Arbeitspunkts entspricht und somit die Wirkleistung P nicht definiert ist.

Gerade bei umrichtergespeisten elektrischen Antrieben ist in der Regel das anwendungsabhängige Lastprofil stark variabel, so zum Beispiel bei einem im normalen Straßenverkehr bewegten Elektrofahrzeug. Die Ermittlung des Wirkungsgrads auf der Grundlage der typischen Wirkleistungsberechnung gemäß der einleitend erläuterten grundlegenden Definition ist daher oft nicht möglich. Ein weiteres Ziel bei der Messauswertung ist die zuverlässige Detektion von Leistungstransienten, beispielsweise zur Überlasterkennung. Die schaltfrequenzbasierte Wirkleistungsbestimmung ist für diese Anforderungen sehr gut geeignet und kann daher neben der Quench-Detektion auch für andere Anwendungen eingesetzt werden.

Wird bei der schaltfrequenzbasierten Wirkleis-

tungsberechnung die Schaltperiode $T_s$ unterschritten und somit das Mittelungsintervall der Leistungsberechnung weiter verkürzt, führt dies zu inadäquaten Ergebnissen. In diesem Fall stimmt die schaltfrequenzbasierte Wirkleistung $P_s$ im stationär eingeschwungenen Zustand auch unter den vorstehend beschriebenen idealisierten Rahmenbedingungen nicht mit der herkömmlichen grundschwingungsfrequenzbasierten Wirkleistung P überein. Der Wirkleistungswert ist im Falle eines stationären Arbeitspunkts auch nicht näherungsweise konstant. Man erhält daher eine Leistungsgröße, welche weder als Augenblicksleistung, noch als Wirkleistung interpretiert werden kann. Somit kann die beschriebene neuartige Definition der Wirkleistung auf der Grundlage der Schaltperiode $T_s$ nicht mehr mit der ursprünglichen Definition der Wirkleistung in Verbindung gebracht werden kann.

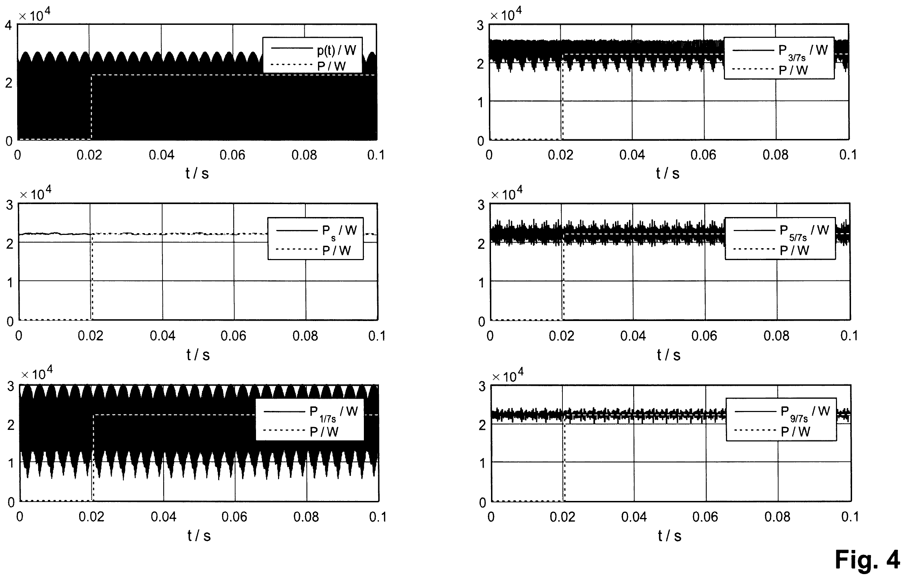

In Fig. 4 sind Leistungsbeziehungen bei einer Variation des Mittelungsintervalls dargestellt. Es sind Berechnungsergebnisse der Augenblicksleistung p(t), der grundschwingungsfrequenzbasierten Wirkleistung P, der schaltfrequenzbasierten Wirkleistung $P_s$ sowie einer Wirkleistung $P_{\upsilon S}$, bei der das Mittelungsintervall im Vergleich zur Schaltperiode $T_S$ mit dem Faktor u multipliziert worden ist, d. h.

$$P_{\nu S} = \frac{1}{\nu \cdot T_S} \cdot \int_{t}^{t+\nu \cdot T_S} u(\tau) \cdot i(\tau) \, d\tau$$

gilt.

Die Simulation, auf deren Ergebnissen Fig. 4 basiert, ist exemplarisch mit einer Grundschwingungsfrequenz f von 50 Hz, einer Schaltfrequenz $f_S$ von 8 kHz, einer Zwischenkreisspannung von 600 V und sinusförmigen Strangströmen mit einer Amplitude von 50 A durchgeführt worden. Als Resultat zeigt sich, dass die schaltfrequenzbasierte Wirkleistung $P_S$ für das der Schaltperiode $T_S$ entsprechende Mittelungsintervall sehr gut mit der grundschwingungsfrequenzbasierten Wirkleistung P übereinstimmt (siehe linke Seite von Fig. 4 in der Mitte). Hingegen liefern alle bezogen auf die Schaltperiode $T_S$ nicht ganzzahlig vielfachen Mittelungsintervalle inadäquate Ergebnisse, die schlecht zu interpretieren sind (siehe linke Seite von Fig. 4 unten und gesamte rechte Seite von Fig. 4). Somit wirkt sich die Nichteinhaltung der Schaltperiode $T_S$ oder eines ganzzahligen Vielfachen derselben als Mittelungsintervall bei der schaltfrequenzbasierten Wirkleistungsberechnung negativ aus.

Dies liegt daran, dass bei einer Sinus-Pulsweitenmodulation der Mittelwert der Spannung über eine Schaltperiode ungefähr dem Wert der sinusförmigen Referenzfunktion entspricht. Für rein sinusförmige Größen ist die Augenblicksleistung in einem stationären Zustand ohnehin zu jedem Zeitpunkt konstant und entspricht der Wirkleistung. Durch die Mittelung über die Schaltperiode wird bei Sinusmodulation somit die entsprechende Berechnung für tatsächlich sinusförmige Größen approximiert.

Die schaltfrequenzbasierte Wirkleistungsberechnung ermöglicht weiterführende Analysen und Auswertungen. Da wie in Fig. 3 und Fig. 3a dargestellt die schaltfrequenzbasierte Wirkleistung $P_S$ die Information über ein transientes Überschwingen bei Arbeitspunktänderungen und Ausgleichsvorgängen enthält, können in Anwendungen, bei welchen die Wirkleistung geregelt wird, die Dynamik und die Regelgüte erhöht werden. Die schaltfrequenzbasierte Wirkleistungsberechnung erlaubt auch eine Detektion von Leistungsspitzen bei transienten Ausgleichsvorgängen, welche mit der herkömmlichen grundschwingungsfrequenzbasierten Wirkleistungsberechnung nicht erkannt werden. Diese können zur Systemüberwachung hinsichtlich der kurzzeitigen Maximalbelastungsgrenze analysiert werden. Wird auf einem Messgerät ein Maschinenmodell implementiert, welches mithilfe der Messgrößen und einer daraus abgeleiteten Parameteradaption der realen Maschine nachgeführt wird, so lässt sich dieses aufgrund des stark verkürzten Mittelungsintervalls wesentlich schneller an die reale Maschine angleichen. Neben diesen Beispielen sind weitere Anwendungen möglich.

Zusammenfassend bezieht sich die vorliegende Erfindung auf ein Verfahren zur schaltfrequenzbasierten Bestimmung der Wirkleistung einer elektrischen Einrichtung 3, insbesondere einer supraleitenden elektrischen Einrichtung, und eine Vorrichtung 4 zum Ausführen des Verfahrens. Die elektrische Einrichtung 3 ist eine mehrphasige elektrische Einrichtung und wird über einen mit einer Energiequelle oder -senke 1 verbundenen Stromrichter 2 mit einer Spannung, die eine frequenz- und amplitudenvariable Grundschwingung mit einer Grundschwingungsperiode T aufweist, versorgt oder führt dem Stromrichter 2 eine derartige Spannung zu. Die schaltfrequenzbasierte Wirkleistungsbestimmung ermöglicht eine schnelle Quench-Detektion ohne den Einsatz von zusätzlichen Sensoren und darüber hinaus die dynamische und genaue Bestimmung des Wirkungsgrads der elektrischen Einrichtung 3.

**Patentansprüche**

1. Verfahren zur schaltfrequenzbasierten Bestimmung einer Wirkleistung einer mehrphasigen elektrischen Einrichtung (3), die über einen Stromrichter (2) mit einer Spannung, die eine frequenz- und amplitudenvariable Grundschwingung mit einer Grundschwingungsperiode T aufweist, versorgt wird oder dem Stromrichter (2) eine derartige Spannung zuführt, wobei das Verfahren die folgenden Schritte umfasst:

   - Messen (S1) von Spannungen $u_{1i} = u_1(i \cdot T_{ABTAST})$ bis $u_{xi} = u_x(i \cdot T_{ABTAST})$ und Strömen $i_{1i} = i_1(i \cdot T_{ABTAST})$ bis $i_{xi} = i_x(i \cdot T_{ABTAST})$ der

elektrischen Phasen für Zeitpunkte $i \cdot T_{ABTAST}$, wobei x eine Anzahl der elektrischen Phasen ist und $T_{ABTAST}$ eine Abtastzeit einer für die Messung verwendeten Messeinrichtung ist;
- Speichern (S2) der gemessenen Spannungen $u_{1i}$ bis $u_{xi}$ und Ströme $i_{1i}$ bis $i_{xi}$;
- Berechnen (S3) von Augenblicksleistungen $p_i = p(i \cdot T_{ABTAST})$ als jeweilige Summe der Produkte $u_{1i} \cdot i_{1i}$ bis $u_{xi} \cdot i_{xi}$ der gemessenen Spannungen und Ströme für den entsprechenden Zeitpunkt;
- Ermitteln (S4) einer Schaltperiode $T_S$ des Stromrichters (2); und
- Bestimmen (S5) einer Wirkleistung $P_S$ der elektrischen Einrichtung (3) als Mittelwert der Augenblicksleistungen $p_i$ zu Zeitpunkten innerhalb der Schaltperiode $T_S$.

2. Verfahren nach einem der vorhergehenden Ansprüche, wobei die elektrische Einrichtung (3) eine elektrische Einrichtung mit einem Supraleiter ist und die folgenden Schritte ausgeführt werden:

- Analysieren (S6) der bestimmten Wirkleistung $P_S$ zum Detektieren eines Übergangs des Supraleiters von dem supraleitenden Zustand zu dem normalleitenden Zustand in zumindest einem Teil des Supraleiters; und
- Unterbrechen (S7) eines Energieflusses zwischen dem Stromrichter (2) und der elektrischen Einrichtung (3), wenn ein Übergang in den normalleitenden Zustand detektiert wird.

3. Verfahren nach einem der vorhergehenden Ansprüche, wobei in dem Schritt des Ermittelns (S4) die Schaltperiode $T_S$ auf der Grundlage des Verlaufs einer Ausgangsspannung des Stromrichters (2) für eine der elektrischen Phasen ermittelt wird.

4. Verfahren nach einem der vorhergehenden Ansprüche, wobei $T_S \le T/5$ gilt.

5. Verfahren nach einem der vorhergehenden Ansprüche, wobei $T_S \le T/100$ gilt.

6. Verfahren nach einem der vorhergehenden Ansprüche, mit den Schritten:

- Analysieren (S8) der bestimmten Wirkleistung $P_S$ zum Detektieren einer Transiente in der Augenblicksleistung p(t);
- Ermitteln (S9) eines bei der detektierten Transiente erreichten Leistungsspitzenwerts; und
- Bestimmen (S10), ob der erreichte Leistungsspitzenwert einen Grenzwert für eine kurzzeitige Maximalleistung überschreitet.

7. Verfahren nach einem der vorhergehenden Ansprüche, mit den Schritten:

- Analysieren (S11) der bestimmten Wirkleistung $P_S$ zum Detektieren eines Übergangs zwischen unterschiedlichen Arbeitspunkten der elektrischen Einrichtung (3); und
- Regeln (S12) der Wirkleistung der elektrischen Einrichtung (3) unter Berücksichtigung des detektierten Übergangs.

8. Verfahren nach einem der vorhergehenden Ansprüche, wobei Verfahrensschritte zyklisch wiederholt werden.

9. Vorrichtung (4) zum Ausführen eines Verfahrens nach einem der vorhergehenden Ansprüche.

10. System mit einer Energiequelle oder -senke (1), einem Stromrichter (2), einer elektrischen Einrichtung (3) und einer Vorrichtung (4) nach Anspruch 9.

**Claims**

1. A method for determining, on the basis of the switching frequency, the active power of a multiphase electrical device (3) which is supplied via a power converter (2) with a voltage having a fundamental of variable frequency and amplitude and having a fundamental period T, or which supplies the power converter (2) with such a voltage, the method comprising the following steps:

- measuring (S1) voltages $u_{1i} = u_1(i \cdot T_{ABTAST})$ to $u_{xi} = u_x(i \cdot T_{ABTAST})$ and currents $i_{1i} = i_1(i \cdot T_{ABTAST})$ to $i_{xi} = i_x(i \cdot T_{ABTAST})$ of the electric phases for times $i \cdot T_{ABTAST}$, where x is a number of electrical phases and $T_{ABTAST}$ is a sampling time of a measuring device used for the measuring;
- storing (S2) the measured voltages $u_{1i}$ to $u_{xi}$ and currents $i_{1i}$ to $i_{xi}$;
- calculating (S3) instantaneous powers $p_i = p(i \cdot T_{ABTAST})$ as the respective sum of products $u_{1i} \cdot i_{1i}$ to $u_{xi} \cdot i_{xi}$ of the measured voltages and currents for the respective time;
- determining (S4) a switching period $T_S$ of the power converter (2); and
- determining (S5) an active power $P_S$ of the electrical device (3) as the mean value of the instantaneous powers $p_i$ at times within the switching period $T_S$.

2. The method according to any one of the preceding claims, wherein the electrical device (3) is an electrical device comprising a superconductor and the following steps are performed:

- analysing (S6) the determined active power $P_S$ to detect a transition of the superconductor from the superconducting state to the normal conducting state in at least part of the superconductor; and

- interrupting (S7) a flow of energy between the power converter (2) and the electrical device (3) when a transition into the normal conducting state is detected.

**3.** The method according to any one of the preceding claims, wherein the switching period $T_S$ is determined in the determining step (S4) on the basis of an output voltage curve of the power converter (2) for one of the electrical phases.

**4.** The method according to any one of the preceding claims, wherein $T_S \leq T/5$.

**5.** The method according to any one of the preceding claims, wherein $T_S \leq T/100$.

**6.** The method according to any one of the preceding claims, comprising the steps of:

- analysing (S8) the determined active power $P_S$ to detect a transient in the instantaneous power p(t);
- determining (S9) a peak power value reached at the detected transient; and
- determining (S10) whether the peak power value reached exceeds a threshold value for a short-term maximum power.

**7.** The method according to any one of the preceding claims, comprising the steps of:

- analysing (S11) the determined active power $P_S$ for detecting a transition between different operating points of the electrical device (3); and
- controlling (S12) the active power of the electrical device (3), taking the detected transition into account.

**8.** The method according to any one of the preceding claims, wherein steps of the method are cyclically repeated.

**9.** A device (4) for performing the method according to any one of the preceding claims.

**10.** A system comprising an energy source or sink (1), a power converter (2), an electrical device (3) and a device (4) according to claim 9.

**Revendications**

**1.** Procédé de détermination, sur la base de la fréquence de commutation, d'une puissance active d'un équipement électrique polyphasé (3) qui est alimenté par un convertisseur de puissance (2) avec une tension ayant une oscillation fondamentale variable en fréquence et en amplitude avec une période d'oscillation fondamentale T, ou qui fournit une telle tension au convertisseur de puissance (2), le procédé comprenant les étapes suivantes consistant à :

- mesurer (S1) des tensions $u_{1i} = u_1(i \cdot T_{ABTAST})$ jusqu'à $u_{xi} = u_x(i \cdot T_{ABTAST})$ et des courants $i_{1i} = i_1(i \cdot T_{ABTAST})$ jusqu'à $i_{xi} = i_x(i \cdot T_{ABTAST})$ de phases électriques pour des instants $i \cdot T_{ABTAST}$, où $x$ est le nombre de phases électriques et $T_{ABTAST}$ est un temps d'échantillonnage d'un équipement de mesure utilisé pour la mesure ;
- stocker (S2) les tensions mesurées $u_{1i}$ jusqu'à $u_{xi}$ et les courants mesurés $i_{1i}$ jusqu'à $i_{xi}$ ;
- calculer (S3) les puissances instantanées $p_i = p(i \cdot T_{ABTAST})$ comme la somme respective des produits $u_{1i} \cdot i_{1i}$ jusqu'à $u_{xi} \cdot i_{xi}$ des tensions et courants mesurés pour l'instant correspondant ;
- déterminer (S4) une période de commutation $T_S$ du convertisseur de puissance (2) ; et
- déterminer (S5) une puissance active $P_S$ de l'équipement électrique (3) en tant que valeur moyenne des puissances instantanées $p_i$ aux instants se trouvant dans la période de commutation $T_S$.

**2.** Procédé selon l'une des revendications précédentes, dans lequel l'équipement électrique (3) est un équipement électrique comprenant un supraconducteur, et dans lequel sont effectuées les étapes suivantes consistant à :

- analyser (S6) la puissance active déterminée $P_S$ pour détecter un passage du supraconducteur de l'état supraconducteur à l'état conducteur normal dans au moins une partie du supraconducteur ; et
- interrompre (S7) un flux d'énergie entre le convertisseur de puissance (2) et l'équipement électrique (3) lorsqu'un passage à l'état conducteur normal est détecté.

**3.** Procédé selon l'une des revendications précédentes, dans lequel, à l'étape de détermination (S4), la période de commutation $T_S$ est déterminée sur la base de la courbe de tension d'une tension de sortie du convertisseur de puissance (2) pour l'une des phases électriques.

**4.** Procédé selon l'une des revendications précédentes, dans lequel $T_S \leq T/5$.

**5.** Procédé selon l'une des revendications précédentes, dans lequel $T_S \leq T/100$.

6. Procédé selon l'une des revendications précédentes, comprenant les étapes consistant à:

   - analyser (S8) la puissance active déterminée $P_S$ pour détecter un transitoire dans la puissance instantanée p(t);
   - déterminer (S9) une valeur crête de puissance atteinte pour le transitoire détecté; et
   - déterminer (S10) si la valeur crête de puissance atteinte dépasse une valeur limite de puissance maximale sur une courte durée.

7. Procédé selon l'une des revendications précédentes, comprenant les étapes consistant à:

   - analyser (S11) la puissance active déterminée $P_S$ pour détecter un passage entre différents points de fonctionnement de l'équipement électrique (3); et
   - régler (S12) la puissance active de l'équipement électrique (3) en tenant compte du passage détecté.

8. Procédé selon l'une des revendications précédentes, dans lequel des étapes du procédé sont répétées de manière cyclique.

9. Dispositif (4) d'exécution d'un procédé selon l'une des revendications précédentes.

10. Système comprenant une source ou puits d'énergie (1), un convertisseur de puissance (2), un équipement électrique (3) et un dispositif (4) selon la revendication 9.

Fig. 1

**Fig. 2**

Fig. 3

EP 3 639 044 B1

Fig. 3a

Fig. 3b

EP 3 639 044 B1

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 3336526 A
- WO 2010018424 A1
- US 5301121 A